# EUROPEAN PATENT APPLICATION

(11) **EP 0 818 272 A1**
(43) Date of publication of application: **14.01.1998**
(21) Application number: 97305145.1
(22) Date of filing: 11.07.1997
(51) Int. Cl.: B24B 37/04, B24D 9/10

(54) **Holding a polishing pad on a platen in a chemical mechanical polishing system**

(30) Priority: 12.07.1996 US 679137
(71) Applicant: Applied Materials, Inc., Santa Clara, CA 95054 (US)
(72) Inventor: Bartlett, William R., Los Gatos, California 95030 (US); Shendon, Norm, San Carlos, California 94070 (US)
(74) Representative: Bayliss, Geoffrey Cyril

(57) **Abstract**

The disclosure relates to a chemical mechanical polishing apparatus which includes a rotatable platen (30) having a surface for receiving a polishing pad (32) and a passageway (220, 232) passing therethrough to the surface. A pump (200) evacuates air from the passageway to hold the polishing pad against the surface of the platen.

## Description

The present invention relates generally to chemical mechanical polishing of substrates, and more particularly to holding a polishing pad on a platen in a chemical mechanical polishing system.

Integrated circuits are typically formed on substrates, particularly silicon wafers, by the sequential deposition of conductive, semiconductive or insulative layers. After each layer is deposited, the layer is etched to create circuitry features. As a series of layers are sequentially deposited and etched, the outer or uppermost surface of the substrate, i.e., the exposed surface of the substrate, becomes increasingly non-planar. This non-planar outer surface presents a problem for the integrated circuit manufacturer. If the outer surface of the substrate is non-planar, then a photo-resist layer placed thereon is also non-planar. A photo-resist layer is typically patterned by a photolithographic apparatus that focuses a light image onto the photoresist. If the outer surface of the substrate is sufficiently non-planar, then the maximum height difference between the peaks and valleys of the outer surface may exceed the depth of focus of the imaging apparatus, and it will be impossible to properly focus the light image onto the entire outer surface. Therefore, there is a need to periodically planarize the substrate surface to provide a flat surface for photolithography.

Chemical mechanical polishing (CMP) is one accepted method of planarization. This planarization method typically requires that the substrate be mounted on a carrier or polishing head. The exposed surface of the substrate is then placed against a rotating polishing pad. The carrier head provides a controllable load, i.e., pressure, on the substrate to push it against the polishing pad. In addition, the carrier head may rotate to provide additional motion between the substrate and polishing surface. A polishing slurry, including an abrasive and at least one chemically-reactive agent, is supplied to the polishing pad to provide an abrasive chemical solution at the interface between the pad and the substrate. Chemical mechanical polishing is a relatively complex process that differs from simple wet sanding. In a CMP process, the reactive agent in the slurry reacts with the outer surface of the substrate to form reactive sites. The interaction of the polishing pad and abrasive particles with the reactive sites on the substrate results in polishing.

An effective CMP process has a high polishing rate and generates a substrate surface which is finished (lacks small-scale roughness) and flat (lacks large-scale topography). The polishing rate, finish and flatness are determined by the pad and slurry combination, the relative speed between the substrate and pad, and the force pressing the substrate against the pad. The polishing rate sets the time needed to polish a layer. Because inadequate flatness and finish can create defective substrates, the selection of a polishing pad and slurry combination is usually dictated by the required finish and flatness. Given these constraints, the polishing time needed to achieve the required finish and flatness sets the maximum throughput of the polishing apparatus.

An additional consideration in the production of integrated circuits is process and product stability. To achieve a high yield, i.e., a low defect rate, each successive substrate should be polished under similar conditions. Each substrate, in other words, should be polished approximately the same amount so that each integrated circuit is substantially identical.

The abrasion by the substrate wears away the containment media of the fixed-abrasive polishing pad to expose the embedded abrasive particles. Thus, the fixed-abrasive polishing pad is gradually consumed by the polishing process. After a sufficient number of polishing runs (e.g., forty to fifty runs) the polishing pad is entirely consumed and is useless in the polishing process. Once the polishing pad is entirely consumed, it is replaced. Standard non-fixed abrasive pads that are conditioned periodically generally withstand more polishings than fixed-abrasive pads. But once a non-fixed abrasive pad begins to glaze, pad conditioners generally cannot break the glaze evenly, and the pad must be replaced.

One problem in the CMP process is difficulty in replacing the polishing pad on the surface of the platen. Usually the polishing pad is attached to the surface of the platen with an adhesive. Strong physical effort often is required to peel the polishing pad away from surface of the platen. The adhesive then must be removed from the top surface of the platen by scraping and washing with a solvent. Finally, a new polishing pad is adhesively attached to the clean surface of the platen. While the polishing pad is being removed from the platen and a new pad is being attached, the platen is not available for the polishing of substrates. For CMP systems in which fixed abrasive pads are used, the problems are even more acute since fixed abrasive pads must be changed more frequently than standard polishing pads.

In view of the foregoing, there is a need for a chemical mechanical polishing apparatus which optimizes polishing throughput while providing the desired surface flatness and finish. A chemical mechanical polishing apparatus should also include a polishing pad which is detachably connected to the platen.

In one aspect, the invention features a chemical mechanical polishing (CMP) apparatus that includes a rotatable platen having a surface for receiving a polishing pad and a passageway passing therethrough to the surface. The CMP apparatus also includes a pump that evacuates air from the passageway.

Embodiments of the invention may include one or more of the following features. The CMP apparatus may include a chamber that allows evacuated air to pass from the passageway to the pump. The chamber may be configured to receive evacuated air from multiple passageways, and it may reside in a platen base that supports the rotatable platen. The pump and the passageway may be configured to create an airflow on the surface of the platen, and they may be configured to create a substantially uniform differential pressure across the polishing pad. The passageway may consist of an array of holes which may be evenly spaced radially or circumferentially throughout the rotatable platen.

The passageway may be substantially cylindrical in shape. The platen also may include a radial trench formed in its surface that intersects the substantially cylindrical passageway. The CMP apparatus also may include a filter configured to separate non-gaseous substances from the evacuated air.

In another aspect, the invention features a method of holding a polishing pad to a platen in a CMP apparatus. The polishing pad is positioned against a surface of the platen, and suction is applied to a passageway passing through the platen to hold the polishing pad against the surface of the platen.

Embodiments may include one or more of the following features. The suction first may be applied through a chamber that distributes the suction to a plurality of passageways. The suction may be delivered from the passageway to a trench formed in the surface of the platen. The suction may be used to create an airflow across the surface of the platen, and it may be used to create a substantially uniform differential pressure across the polishing pad. The suction may be applied to a plurality of holes formed in the platen. Non-gaseous substances may be filtered from air pulled through the passageway.

In another aspect, the invention features a CMP apparatus that includes a rotatable platen having a top surface for receiving a polishing pad and a plurality of passageways intersecting the surface. At least one of the passageways passes through the platen from a bottom surface to the top surface. The CMP apparatus also includes a vacuum pump connected to the passageways to create suction pressure at the top surface of the platen when the polishing pad is placed on the top surface.

Embodiments may include one or more of the following features. The platen may be formed such that only one of the passageways passes through the platen. The CMP apparatus also may include a platen base that supports the platen. The platen base may include a chamber that distributes the suction pressure to the passageways. The pump and the passageways may be configured to create an airflow across the top surface of the platen, and the airflow may generate a substantially uniform differential pressure across the polishing pad when the polishing pad is placed on the platen.

Advantages of the invention may include one or more of the following. A chemical mechanical polishing (CMP) apparatus reliably attaches and releases a polishing pad at the surface of a platen. Because suction is used to hold the polishing pad to the platen during the polishing process, little physical effort is required to attach and remove the pad when the suction is released, and there is no adhesive to remove from the platen. As a result, CMP system downtime is reduced and throughput is increased substantially. The chucking system may be incorporated into any configuration of a CMP apparatus.

Other advantages of the invention will be set forth in the description which follows, and in part will be obvious from the description, or may be learned by practice of the invention. The advantages of the invention may be realized by the instrumentalities and combinations particularly pointed out in the claims.

The accompanying drawings which are incorporated in and constitute a part of the specification, schematically illustrate embodiments of the invention, and together with the general description given above and the detailed description of the embodiments given below, serve to explain the principles of the invention.

FIG. 1 is a schematic exploded perspective view of a chemical mechanical polishing apparatus.

FIG. 2 is a cross-sectional view of a polishing pad.

FIG. 3 is a schematic cross-sectional view of a platen assembly with a polishing pad chucking system in accordance with the present invention.

FIG. 4 is a bottom view of a platen used with the polishing pad chucking system of FIG. 3.

FIG. 5A is a top view and FIG. 5B is a cross-sectional view of a platen assembly using the chucking system of FIG. 3.

FIG. 6A is a top view and FIG. 6B is a cross-sectional view of a platen assembly using the chucking system of FIG. 3.

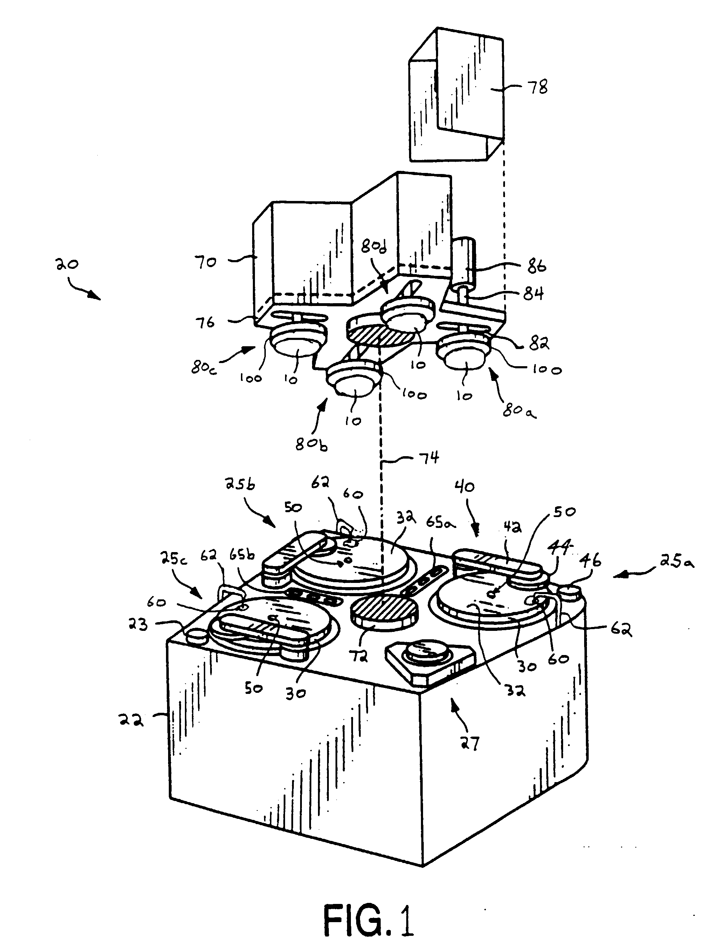

Referring to FIG. 1, one or more substrates 10 may be polished by a chemical mechanical polishing apparatus 20. A complete description of CMP apparatus 20 may be found in U.S. Patent Application Serial No. 08/549,336, entitled RADIALLY OSCILLATING CAROUSEL PROCESSING SYSTEM FOR CHEMICAL MECHANICAL POLISHING and filed October 27, 1995, by Ilya Perlov, et al., assigned to the assignee of the present invention, the entire disclosure of which is incorporated herein by reference. According to the present invention, polishing apparatus 20 includes a lower machine base 22 with a table top 23 mounted thereon and a removable outer cover (not shown). Table top 23 supports a series of polishing stations 25a, 25b and 25c and a transfer station 27. Transfer station 27 forms a generally square arrangement with the three polishing stations 25a, 25b and 25c. Transfer station 27 serves multiple functions, including receiving individual substrates 10 from a loading apparatus (not shown), washing the substrates, loading the substrates into carrier heads (to be described below), receiving the substrates from the carrier heads, washing the substrates again, and finally, transferring the substrates back to the loading apparatus.

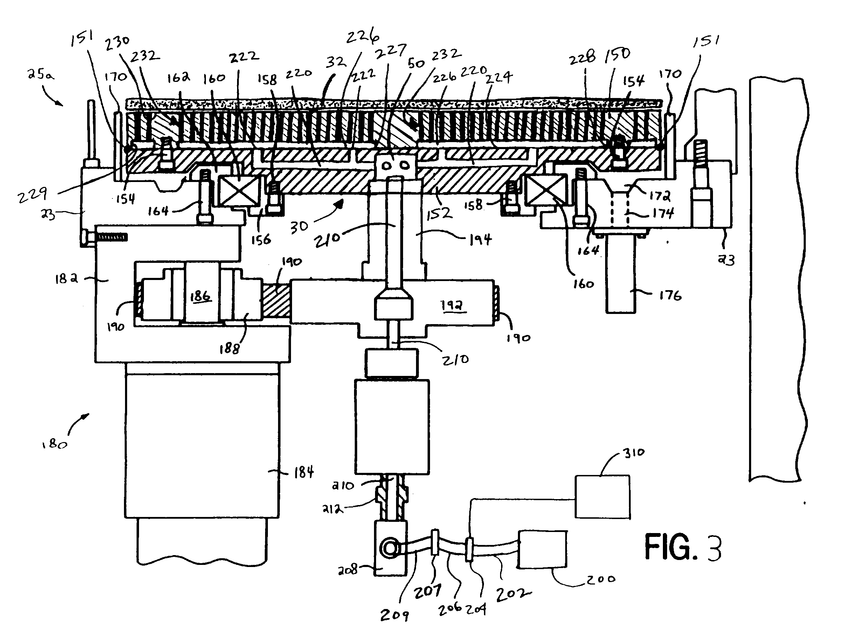

Each polishing station 25a-25c includes a rotatable platen assembly 30 on which is placed a polishing pad 32. If substrate 10 is an eight inch (200 millimeter) diameter disk, then platen assembly 30 and polishing pad 32 will be about twenty inches in diameter. Platen assembly 30 preferably includes a rotatable aluminum or stainless steel plate connected to a platen drive motor (see FIG. 3). For most polishing processes, the platen drive motor rotates platen assembly 30 at thirty to two hundred revolutions per minute, although lower or higher rotational speeds may be used.

In addition, each polishing station includes a polishing pad chucking system, described in detail below, which uses suction to create a pressure differential across the polishing pad and hold the pad on the platen.

Each polishing station 25a-25c also may include an associated pad conditioner apparatus 40, which is used to condition a non-abrasive polishing pad on the platen assembly 30. Each pad conditioner apparatus 40 has a rotatable arm 42 holding an independently rotating conditioner head 44 and an associated washing basin 46. The conditioner apparatus maintains the condition of the polishing pad so it will effectively polish any substrate pressed against it while it is rotating.

A slurry 60 containing a reactive agent (e.g., deionized water for oxide polishing) and a chemically reactive catalyzer (e.g., potassium hydroxide for oxide polishing), is supplied to the surface of polishing pad 32 by a slurry supply tube 62. Sufficient slurry is provided to cover and wet the entire polishing pad 32. Two or more intermediate washing stations 65a and 65b are positioned between neighboring polishing stations 25a, 25b and 25c. The washing stations rinse the substrates as they pass from one polishing station to another.

A rotatable multi-head carousel 70 is positioned above lower machine base 22. Carousel 70 is supported by a center post 72 and is rotated thereon about a carousel axis 74 by a carousel motor assembly located within base 22. Center post 72 supports a carousel support plate 76 and a cover 78. Multi-head carousel 70 includes four carrier head systems 80a, 80b, 80c and 80d. Three of the carrier head systems receive and hold substrates, and polish them by pressing them against the polishing pads 32 on platens 30 of polishing stations 25a-25c. One of the carrier head systems receives a substrate from and delivers a substrate to transfer station 27.

In the preferred embodiment, the four carrier head systems 80a-80d are mounted on carousel support plate 76 at equal angular intervals about carousel axis 74. Center post 72 allows the carousel motor to rotate the carousel support plate 76 and to orbit the carrier head systems 80a-80d and the substrates attached thereto about carousel axis 74.

Each carrier head system 80a-80d includes a carrier or carrier head 100. Each carrier head 100 independently rotates about its own axis, and independently laterally oscillates in a radial slot 82 formed in carousel support plate 76. A carrier drive shaft 84 connects a carrier head rotation motor 86 to carrier head 100 (shown by the removal of one quarter of cover 78). There is one carrier drive shaft and motor for each head.

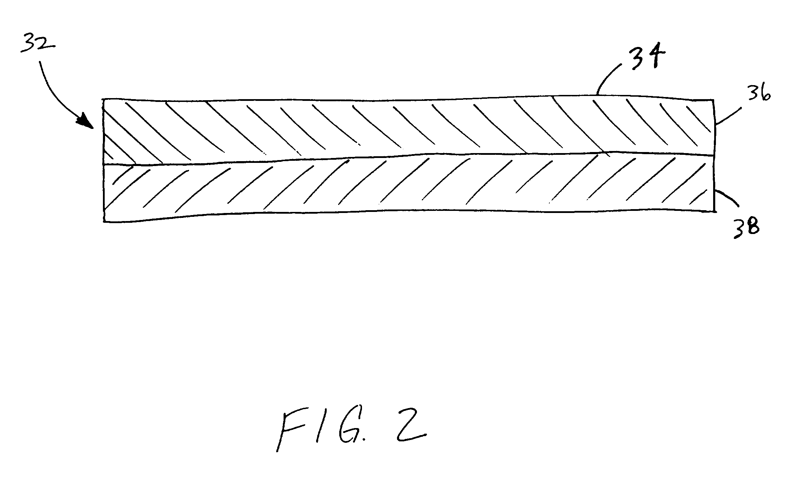

Referring to FIG. 2, if polishing pad 32 is a non-abrasive pad, polishing pad 32 comprises a hard composite material with a roughened polishing surface 34. A non-abrasive polishing pad typically has a fifty mil thick hard upper layer 36 and a fifty mil thick soft lower layer 38. Upper layer 36 is preferably a material composed of polyurethane mixed with fillers. Lower layer 38 is preferably a material composed of felt fibers mixed with urethane. A common two layer polishing pad, with the upper layer composed of IC-1000 and the lower layer composed of SUBA-4, is available from Rodel, Inc., located in Newark, Delaware (IC-1000 and SUBA-4 are product names of Rodel, Inc.).

If polishing pad 32 is a fixed abrasive pad, upper layer 36 is a 25-200 mil thick abrasive composite layer, typically composed of abrasive grains held in a binder material. Lower layer 38 is a 25-200 mil thick backing layer, composed of a material such as polymeric film, paper, cloth, metallic film, or the like. Fixed abrasive polishing pads are described in detail in the following U.S. patents, all of which are incorporated herein by reference: 5,152,917, issued on October 6, 1992, and entitled STRUCTURED ABRASIVE ARTICLE; 5,342,419, issued on August 30, 1994, and entitled ABRASIVE COMPOSITES HAVING A CONTROLLED RATE OF EROSION, ARTICLES INCORPORATING SAME, AND METHODS OF MAKING AND USING SAME; 5,368,619, issued on November 29, 1994, and entitled REDUCED VISCOSITY SLURRIES, ABRASIVE ARTICLES MADE THEREFROM AND METHODS OF MAKING SAID ARTICLES; 5,378,251, issued on January 3, 1995, and entitled ABRASIVE ARTICLES AND METHODS OF MAKING AND USING SAME.

Referring to FIG. 3, each polishing station, such as polishing station 25a, includes a platen assembly 30 that holds a polishing pad. A pad chucking chamber 50, described in detail below, applies a vacuum to the pad to create a differential pressure that holds the pad against the platen assembly 30 during the polishing process.

Platen assembly 30 includes a platen 150 and a platen base 152 joined by several peripheral screws 154 counter-sunk into the bottom of platen base 152. An O-ring 151 or any other suitable object, such as an RTV compound, may be used to form a seal between platen 150 and platen base 152. A first collar 156 is connected by screws 158 to the bottom of platen base 152 to capture the inner race of an annular bearing 160. A second collar 162, connected to table top 23 by a set of screws 164, captures the outer race of annular bearing 160. Annular bearing 160 supports platen assembly 30 above table top 23 while permitting the platen to be rotated by the platen drive motor.

A circular weir 170 surrounds platen assembly 30 and captures slurry and associated liquids centrifugally expelled from platen assembly 30. The slurry collects in a trough 172 formed on table top 23 by weir 170 and second collar 162. The slurry then drains through a hole 174 in table top 23 to a drain pipe 176.

A platen motor assembly 180 is bolted to the bottom of table top 23 through a mounting bracket 182. Platen motor assembly 180 includes a motor 184 with an output shaft 186 extending vertically upwards. Output shaft 186 is fit to a solid motor sheath 188. A drive belt 190 winds around motor sheath 188 and around a hub sheath 192. Hub sheath 192 is joined to platen base 152 by a platen hub 194. Thus, motor 184 may rotate platen assembly 30. Platen hub 194 is sealed to lower platen base 152 and to hub sheath 192.

Pad chucking chamber 50 receives suction pressure from a vacuum source 200, such as a vacuum pump or a "house vacuum" line, that is connected by a fluid line 202 to a computer controlled valve 204. Computer controlled valve 204 is connected by a second fluid line 206 to a filter/separator 207, which prevents liquids and other non-gaseous substances, such as the polishing slurry and loose particles, from entering the vacuum pump 200. The separator 207 in turn is connected by a third fluid line 209 to a rotary coupling 208. Rotary coupling 208 connects the stationary vacuum pump 200 to an axial passage 210 in a rotating motor shaft 212. The axial passage 210 passes through motor shaft 212, platen hub sheath 192, and platen hub 194 into platen base 152, where the axial passage 210 opens into pad chucking chamber 50. Connections between motor shaft 212, platen hub 194, and platen base 152 may be sealed by any suitable means, such as by O-rings, RTV compound, or the like.

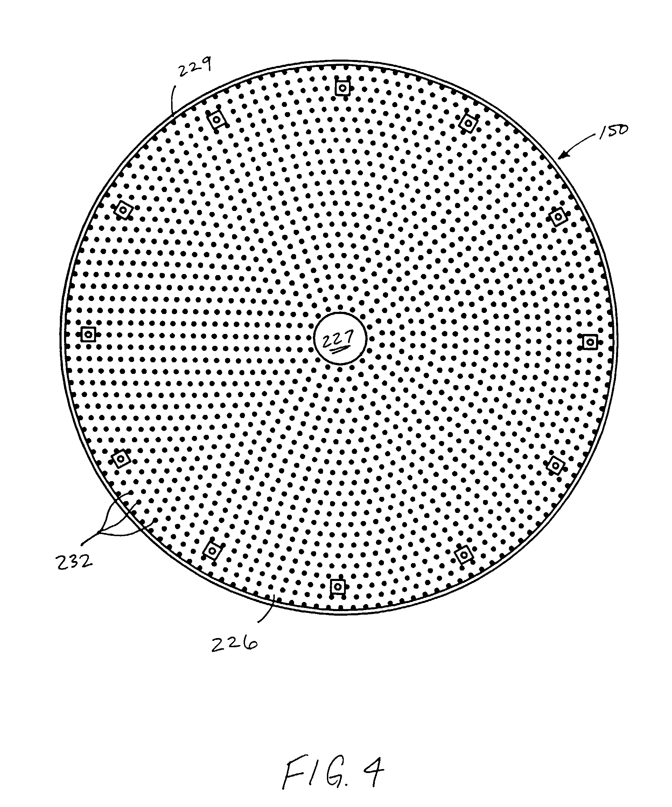

Referring also to Figure 4, pad chucking chamber 50 connects to radial passages 220 in platen base 152. Radial passages 220 lead to openings 222 in the top surface 224 of platen base 152. The openings 222 in turn lead to a recess 226 formed in substantially all of the bottom surface 228 of platen 150. Small cylindrical passages or "holes" 232 pass through platen 150 and connect recess 226 to the upper surface 230 of platen 150. A stud 227 in the center of platen 150 contacts the top surface 224 of platen base 152 to prevent platen 150 from bowing in the middle during the polishing process. Similarly, a lip 229 surrounds recess 226 along the outer circumference of platen 150 both to seal recess 226 and to support the outer circumference of the platen 150 during the polishing process. A typical 20" platen will have approximately 1850 holes 232 with approximately 3/8" radial spacing and 0.44" circumferential spacing. The holes are approximately 0.09" in diameter.

When computer 310 opens valve 204, vacuum pump 200 provides suction through fluid lines 202, 206, and 209 and axial passage 210 to the pad chucking chamber 50. Pad chucking chamber 50 distributes the suction pressure to each of the radial passages 220, which in turn provide the suction pressure to recess 226. Recess 226 distributes the suction pressure among the holes 232, which in turn deliver the suction pressure to polishing pad 32. The relatively uniform pressure differential created across polishing pad 32 generates a net downward pressure that holds the polishing pad 32 on the platen assembly 30. For a typical CMP process using a 20" platen having approximately 1850 holes, vacuum pump 200 should supply a suction pressure of between approximately 20" Hg and 40" Hg to ensure that polishing pad 32 remains on the platen.

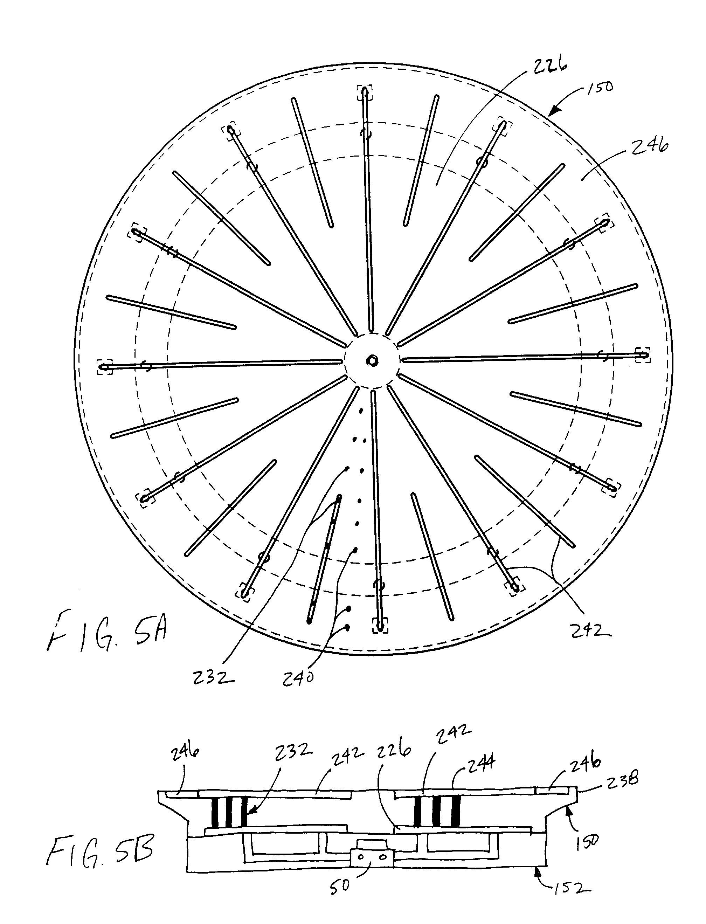

Referring to Figures 5A and 5B, if platen 150 is larger than platen base 152, the passages 232 through platen 150 cannot extend to the outer circumference 238 of the platen 150. Therefore, narrow radial trenches or passageways 242 are formed in the top surface 244 of platen 150 to connect the passages 232, and thus the recess 226, to an outer chamber 246 that passes immediately under the top surface 244 of platen 150 along its outer circumference 238. Holes 240 in the top surface 244 of platen 150 expose the polishing pad to suction pressure from the outer chamber 246 in areas not covered by radial grooves 242.

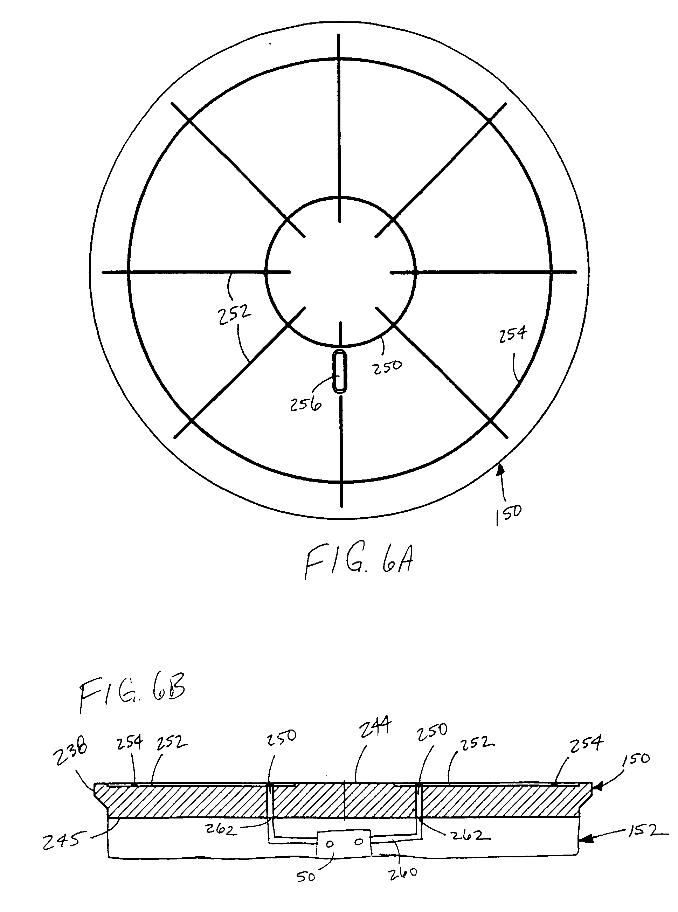

Referring to Figures 6A and 6B, platen 150 instead may include a single cylindrical passage 250 extending through platen 150 from its bottom surface 245 to its top surface 244. Radial passage 260 extending from pad chucking chamber 50 in platen base 152 may be disk-shaped with a circular opening 262 that couples directly with the cylindrical passage 250 in platen 150. Radial trenches or passageways 252 formed in the top surface 244 of platen 150 intersect cylindrical passage 250 and distribute suction pressure from cylindrical passage 250 radially along the top surface 244 of platen 150 toward its outer circumference 238. A circular trench 254 in the top surface 244 of platen 150 intersects radial trenches 252 near the outer circumference 238 of platen 150.

While the polishing pad typically is sufficiently rigid to hold its shape as viewed by the naked eye, it also is sufficiently flexible that pockets of air may build up between the radial trenches and distort the surface of the polishing pad. Therefore, a perfect vacuum is not desirable, but rather some air leakage should be allowed to occur between platen 150 and the polishing pad. This leakage creates an airflow that evacuates air along the top surface 244 of platen 150 in areas lying between radial trenches 252, flattening the surface of the polishing pad. The airflow also creates a substantially uniform differential pressure across the entire polishing pad, ensuring that the polishing pad is held uniformly against platen 150. Vacuum pump 200 must have enough capacity to process the volume of air leaking into the radial trenches. Air leakage also may be desirable for other embodiments of the platen assembly, such as those described above.

Platen 150 and platen base 152 also may include a hole 256 that allows interferometric monitoring of the polishing process. A complete description of the use of laser interferometry to monitor a CMP process may be found in U.S. Patent Application Serial No. 08/605,769, entitled APPARATUS AND METHOD FOR IN-SITU MONITORING OF CHEMICAL MECHANICAL POLISHING OPERATIONS, filed February 22, 1996, by Manoocher Birang et al., and assigned to the assignee of the present invention, the entire disclosure of which is incorporated herein by reference.

The present invention has been described in terms of a preferred embodiment. The invention, however, is not limited to the embodiment depicted and described. Rather, the scope of the invention is defined by the appended claims.

## Claims

1. A chemical mechanical polishing apparatus comprising:
a rotatable platen having a surface for receiving a polishing pad and a passageway that passes through the platen to the surface; and
a pump connected to the passageway to evacuate air from the passageway to hold a pad on that surface.

2. A polishing apparatus as claimed in claim 1, wherein the pump and the passageway are configured to create an airflow on the surface of the platen.

3. A polishing apparatus as claimed in claim 1 or claim 2, wherein the pump and the passageway are configured to create a substantially uniform differential pressure across the polishing pad.

4. A polishing apparatus as claimed in any one of claims 1 to 3, wherein the passageway includes an array of holes located throughout the rotatable platen.

5. A polishing apparatus as claimed in claim 4, wherein the holes are evenly spaced radially.

6. A polishing apparatus as claimed in claim 4, wherein the holes are evenly spaced circumferentially.

7. A polishing apparatus as claimed in any of claims 1 to 6 further comprising a chamber in the passageway between the pump and the platen surface to allow evacuated air to pass from the passageway to the pump.

8. A polishing apparatus as claimed in claims 1 to 7, wherein multiple passageways are provided between the surface and the chamber.

9. A polishing apparatus as claimed in claim 7 or claim 8, wherein the chamber resides in a platen base that supports the rotatable platen.

10. A polishing apparatus as claimed in any one of claims 5 to 9, wherein the passageway is substantially cylindrical in shape.

11. A polishing apparatus as claimed in claim 10 further comprising a radial trench that is formed in the surface of the rotatable platen and that intersects the substantially cylindrical passageway.

12. A polishing as claimed in any one of claims 1 to 11, further comprising a filter configured to separate non-gaseous substances from the evacuated air.

13. A method of holding a polishing pad to a platen in a chemical mechanical polishing apparatus, comprising:
positioning the polishing pad against a surface of the platen, and
applying suction to a passageway passing through the platen to hold the polishing pad against the surface of the platen.

14. A method as claimed in claim 13, further comprising first applying the suction through a chamber that distributes the suction to a plurality of passageways.

15. A method as claimed in claim 13 further comprising delivering suction from the passageway to a trench formed in the surface of the platen.

16. A method as claimed in claim 13, further comprising using the suction to create an airflow across the surface of the platen.

17. A method as claimed in claim 13, wherein the suction creates a substantially uniform differential pressure across the polishing pad.

18. A method as claimed in claim 13, wherein section is applied to a plurality of holes formed in the platen.

19. A method as claimed in claim 13, further comprising filtering non-gaseous substances from air pulled through the passageway.

20. A chemical mechanical polishing apparatus comprising:
a rotatable platen comprising:
a top surface for receiving a polishing pad, and
a plurality of passageways intersecting the surface, at least one of which passes through the platen from a bottom surface to the top surface of the platen, and
a vacuum pump connected to the passageways to create suction pressure at the top surface of the platen when the polishing pad is placed on the top surface.

21. An apparatus as claimed in claim 20, wherein only one of the passageways passes through the platen.

22. An apparatus as claimed in claim 20, further comprising a platen base that supports the platen.

23. An apparatus as claimed in any one of claims 20 to 22, wherein the platen base has a chamber that distributes the suction pressure to the passageways.

24. An apparatus as claimed in any one of claims 20 to 23 wherein the pump and the passageways are configured to create an airflow across the top surface of the platen.

25. An apparatus as claimed in any one of claims 20 to 24, wherein the airflow generates a substantially uniform differential pressure across the polishing pad when the polishing pad is placed on the platen.
